# EUROPÄISCHE PATENTANMELDUNG

(11) **EP 1 808 906 A2**
(43) Veröffentlichungstag der Anmeldung: **18.07.2007**
(21) Anmeldenummer: 06124372.1
(22) Anmeldetag: 20.11.2006
(51) Int. Cl.: H01L 41/04, H01L 41/083

(54) **Piezoaktor mit verbesserter Sicherheit gegen Kurzschlüsse**

(30) Priorität: 12.01.2006 DE 102006001573
(71) Anmelder: ROBERT BOSCH GMBH, 70442 Stuttgart (DE)
(72) Erfinder: Pauer, Thomas, 71691, Freiberg (DE); Boecking, Friedrich, 70499, Stuttgart (DE)

(57) **Zusammenfassung**

Es wird ein Piezoaktor (1) vorgeschlagen, der eine Ummantelung (9) aufweist, die einerseits eine hohe Kurzschlusssicherheit des Piezoaktors gewährleistet und andererseits in ihren mechanischen und thermischen Eigenschaften weitestgehend dem eigentlichen Piezoaktor 1 entspricht.

## Beschreibung

### Stand der Technik

Die Erfindung betrifft einen Piezoaktor, beispielsweise zur Betätigung eines mechanischen Bauteils, mit den gattungsgemäßen Merkmalen des Hauptanspruchs.

Piezoaktoren werden mit großem Erfolg zum Beispiel in Injektoren von modernen Kraftstoffeinspritzsystemen für Brennkraftmaschinen, aber auch in elektrisch betätigten Ventilen für Fahrsicherheitssysteme, wie ABS oder einer Anti-Schlupf-Regelung, eingesetzt.

Der piezoelektrisch aktive Bereich eines Piezoaktors besteht aus einer Vielzahl von übereinander gestapelten Schichten metallisierter Piezokeramiken. Diese metallisierten Piezokeramiken bilden einen sogenannten Multilayer-Aktor. Zwischen den Schichten des Piezoaktors sind Innenelektroden aus einem metallischen Werkstoff, wie zum Beispiel Silber oder Kupfer, angeordnet mit deren Hilfe ein elektrisches Feld in den piezoelektrischen Keramikschichten des Piezoaktors angelegt werden kann. Das elektrische Feld verursacht eine Längenänderung der Piezokeramik.

Aus der DE 102 37 589 A1 ist ein Piezoaktor bekannt, der den zuvor beschriebenen Multilayeraufbau aufweist. Am Kopf- und Fußbereich dieses Piezoaktors sind piezoelektrisch inaktive Bereiche vorgesehen, in denen keine Innenelektroden vorhanden sind. Infolgedessen wird in diesen inaktiven Bereichen auch keine elektrische Spannung angelegt.

Es hat sich bei diesen aus dem Stand der Technik bekannten Multilayerpiezoaktoren als vorteilhaft erwiesen, wenn die piezoelektrisch nicht aktiven Bereiche aus einem Material bestehen, das hinsichtlich seiner mechanischen und thermischen Eigenschaften weitestgehend an die Eigenschaften des piezoelektrisch aktiven Bereichs des Piezoaktors angepasst werden.

Der Erfindung liegt die Aufgabe zu Grunde die aus dem Stand der Technik bekannten Piezoaktoren hinsichtlich Kurzschlusssicherheit weiter zu verbessern und die Lebensdauer der erfindungsgemäßen Piezoaktoren zu erhöhen.

### Offenbarung der Erfindung

Diese Aufgabe wird erfindungsgemäß bei einem Piezoaktor mit mehreren Schichten, wobei in einem piezoelektrisch aktiven Bereich zwischen den Schichten Innenelektroden vorgesehen sind und wobei die Innenelektroden mit einer elektrischen Spannung beaufschlagbar sind, dadurch gelöst, dass der piezoelektrisch aktive Bereich mit einer elektrisch nichtleitenden Ummantelung gegen elektrische Kurzschlüsse geschützt ist, und dass die Ummantelung aus einem Material besteht, dessen mechanische und thermische Eigenschaften den Eigenschaften des piezoelektrisch aktiven Bereichs weitestgehend entsprechen.

### Vorteile der Erfindung

Mit Hilfe der erfindungsgemäßen Ummantelung ist es möglich, den eigentlichen Piezoaktor vollständig zu ummanteln und, da die Ummantelung aus einem elektrisch nicht leitenden Material besteht, elektrisch zuverlässig gegen die im Betrieb auftretenden Spannungen zu isolieren. Dadurch können über die gesamte Lebensdauer des Piezoaktors mit hoher Zuverlässigkeit Kurzschlüsse zwischen dem Piezoaktor und ein den Piezoaktor umgebendes Gehäuse oder dessen sonstige Umgebung vermieden werden.

Vorteilhafterweise besteht die Ummantelung aus einem gleichen Grundwerkstoff, wie der piezoelektrisch aktive Bereich des Piezoaktors. Durch gezielte Modifikationen des für die Ummantelung eingesetzten Grundwerkstoffs, kann die gewünschte Übereinstimmung der mechanischen und thermischen Eigenschaften der Piezokeramik und deren Ummantelung erreicht werden. Außerdem ist der Grundwerkstoff relativ preisgünstig, so das die Kosten für die Ummantelung relativ niedrig sind. Außerdem kann die Ummantelung mit relativ geringem zusätzlichen Aufwand in eine bestehende Serienfertigung von Piezoaktoren integriert werden. Dadurch ergeben sich erhebliche wirtschaftliche Vorteile, die besonders bei der Fertigung großer Serien von entscheidender Bedeutung für den Markterfolg sein können.

Im Zusammenhang mit der Erfindung ist eine wichtige mechanische Eigenschaft der Elastizitätsmodul, während eine wichtige thermische Eigenschaft die Wärmedehnung ist. Wenn Elastizitätsmodul und Wärmedehnung der Ummantelung möglichst genau den Eigenschaften des piezoelektrisch aktiven Bereichs entsprechen, werden die erfindungsgemäßen Vorteile in höchstem Maße erreicht. Es versteht sich von selbst, dass oftmals nicht eine hundertprozentige Übereinstimmung in einer oder beiden dieser genannten Eigenschaften erzielt werden kann, jedoch hat sich schon auch bei weitgehender Übereinstimmung der wichtigsten mechanischen und thermischen Eigenschaften eine drastische Verringerung von Brüchen oder Rissen in der Ummantelung des Piezoaktors eingestellt. Solange die Ummantelung frei von Brüchen oder Rissen bleibt, ist auch deren Isolationswirkung unvermindert.

Dabei ist darauf zu achten, dass die mechanischen und thermischen Eigenschaften des piezoelektrisch aktiven Bereichs durch die Schichten piezoelektrischen Materials und die Innenelektroden sowie deren Wechselwirkungen miteinander bestimmt werden. Dies gilt umso mehr als die Piezoaktoren in der Regel aus keramischen Werkstoffen durch Sintern hergestellt werden und beim Sintern so hohe Temperaturen auftreten, dass Spuren der metallischen Innenelektroden in das piezoelektrische Material eindiffundieren und dort eine Dotierung des piezoelektrischen Materials bewirken. Diese Dotierung bewirkt in der Regel, durchaus signifikante Änderungen der mechanischen und/oder thermischen Eigenschaften des piezoelektrischen Materials und ist deshalb bei der Anpassung des Materials der Ummantelung an den Piezoaktor zu berücksichtigen.

Es hat sich weiter als vorteilhaft erwiesen, dass der Piezoaktor Außenelektroden, bevorzugt zwei Außenelektroden, aufweist, dass jede Innenelektrode mit einer Außenelektrode elektrisch leitend verbunden ist und dass die Außenelektroden im Wesentlichen außerhalb der Ummantelung angeordnet sind. Dadurch ist es auf einfache Weise möglich, über die Außenelektroden und durch die Ummantelung hindurch die erforderliche elektrische Spannung bei Bedarf an den Innenelektroden anzulegen.

Besonders vorteilhaft ist es, wenn die Ummantelung durch Tauchen des Rohlings (auch als Grünling bezeichnet) eines Piezoaktors in einen Gießschlicker und anschließendes Sintern des Rohlings hergestellt wird. Dadurch kann die Ummantelung jede beliebige Form annehmen. Außerdem hat die Ummantelung keine Fugen und ist von sehr gleichmäßiger Dicke.

Alternativ ist es auch möglich, dass die Ummantelung aus einer Folie besteht, die um den Piezoaktor gewickelt wird. Naturgemäß ergibt sich bei einer aus einer Folie gebildeten Ummantelung dort wo zwei Enden der Folie aufeinandertreffen einen Stoß. Um auch in diesem Bereich eine gleichbleibend hohe Kurzschlusssicherheit zu haben, ist erfindungsgemäß vorgesehen, dass die Innenelektroden einen Mindestabstand zu dem Stoß nicht unterschreiten.

Zur weiteren Erhöhung der Kurzschlusssicherheit der Ummantelung im Bereich des Stoßes, kann der Stoß durch eine Leiste, einen Stopfen oder eine Vergussmasse verschlossen werden.

Es hat sich als vorteilhaft erwiesen, wenn bei Piezoaktoren, deren Innenelektroden aus Silber oder einer Silberlegierung, insbesondere einer Silberpalladiumlegierung, bestehen, die Ummantelung und/oder die piezoelektrisch inaktiven Bereiche aus einem mit Silber dotierten keramischen Werkstoff bestehen.

Wenn die Innenelektroden aus Kupfer oder einer Kupferlegierung bestehen, wird die Ummantelung und/oder die piezoelektrisch inaktiven Bereiche bevorzugt aus einem mit Kupfer dotierten keramischen Werkstoff hergestellt.

Die der Erfindung zu Grunde liegende Aufgaben wird ebenfalls durch ein Verfahren zur Herstellung einer Ummantelung eines Piezoaktors gelöst, bei dem ein Grünling (ungesinterter Rohling) des Piezoaktors in einen Gießschlicker getaucht wird, und anschließend der Grünling gesintert wird. Dadurch ergibt sich mit geringem fertigungstechnischen Aufwand eine den Piezoaktor vollständig umschließende Ummantelung, wobei der Piezoaktor nahezu beliebige Formen aufweisen kann. Durch das Tauchen wird außerdem erreicht, dass die Ummantelung eine sehr gleichmäßige Dicke hat, so dass der Schutz gegen Kurzschlüsse in allen Bereichen des Piezoaktors gleich gut ist.

Besonders vorteilhaft ist es, wenn der Gießschlicker aus einem mit einem Metallsalz versetzten keramischen Werkstoff, insbesondere aus Bleizirkonattitanat besteht.

Als besonders vorteilhaft hat es sich erwiesen, wenn der Gießschlicker mit Silbersalzen und/oder Kupfersalzen versetzt ist. Beim Sintern bewirken die Metallsalze eine Dotierung des keramischen Werkstoffes der Ummantelung.

Weitere Vorteile und vorteilhafte Ausgestaltungen der Erfindung sind der nachfolgenden Zeichnung, deren Beschreibung und den Patentansprüchen entnehmbar. Alle in der Zeichnung, deren Beschreibung und den Patentansprüchen offenbarten Merkmale können sowohl einzeln als auch in beliebiger Kombination miteinander erfindungswesentlich sein.

### Zeichnungen

Es zeigen
- Figur 1: einen aus dem Stand der Technik bekannten Piezoaktor im Längsschnitt, und
- Figuren 2 bis 5: Ausführungsbeispiele erfindungsgemäßer Piezoaktoren im Querschnitt.

### Beschreibung der Ausführungsbeispiele

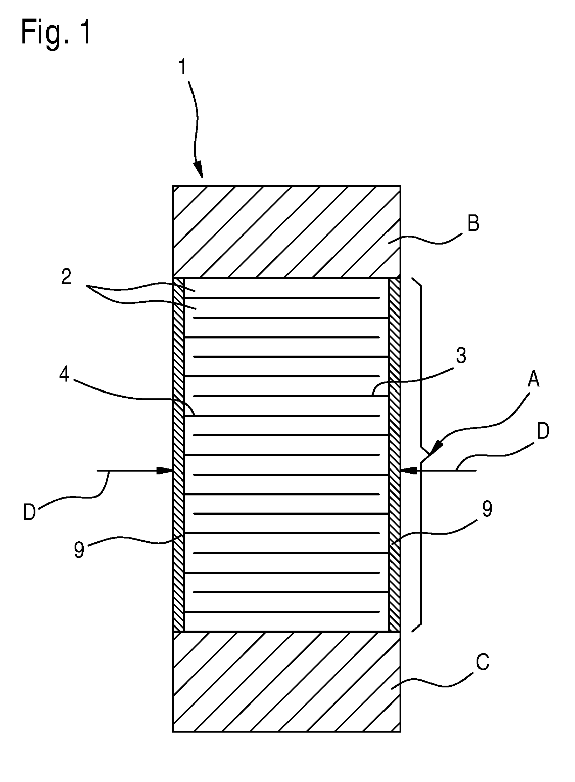

In Figur 1 ist ein herkömmlicher Piezoaktor im Längsschnitt dargestellt. In einem piezoelektrisch aktiven Bereich A ist der in Figur 1 dargestellte Piezoaktor 1 aus verschiedenen Schichten 2 eines piezoelektrischen keramischen Materials aufgebaut.
Die Schichten 2 werden in an sich bekannter Weise aus sogenannten Grünfolien hergestellt. Diese Grünfolien können beispielsweise Keramiken auf der Basis von Bleizirkonattitanat (PZT) sein. Zwischen den Schichten 2 sind Innenelektroden 3 und 4 im Wechsel angeordnet. Die Kontaktierung der Innenelektroden 3 und 4 ist in Figur 1 nicht dargestellt.

Mindestens in dem piezoelektrisch aktiven Bereich A ist eine erfindungsgemäße Ummantelung 9 vorhanden, die eine elektrische Isolierung des Bereichs A bewirkt und diesen Bereich gegen äußere Einflüsse abschirmt.

Oberhalb und Unterhalb des piezoelektrisch aktiven Bereichs A sind piezoelektrisch inaktive Bereiche B und C angeordnet. Diese am Kopf- und am Fußende angebrachten inaktiven Bereiche dienen sowohl der elektrischen Isolierung als auch zur Aufnahme von Druckkräften beziehungsweise zur Ableitung der von dem Piezoaktor 1 auf beispielsweise den Steller eines Injektors einer Brennkraftmaschine ausgeübte Stellkraft. Sie sind üblicherweise aus dem gleichen Grundwerkstoff wir der piezoelektrisch aktive Bereich A herstellt.

Grundwerkstoff des piezoelektrisch aktiven Bereichs A, der piezoelektrisch inaktiven Bereiche B und C sowie der Ummantelung 9 kann eine Keramik beispielsweise auf der Basis von Bleizirkontitanat (PZT) sein. Diese oder andere Keramiken können zur Herstellung der Ummantelung 9 durch Hinzufügen geeigneter Dotierstoffe, wie zum Beispiel Silber oder Kupfer, in ihren thermischen und mechanischen Eigenschaften so verändert werden, dass die Ummantelung 9 in ihren thermischen und mechanischen Eigenschaften dem piezoelektrischen aktiven Bereich A des Piezoaktors 1 mit den Schichten 2 und den Innenelektroden 3 und 4 weitestgehend entspricht. Bei der Anpassung des Werkstoffs der Ummantelung 9 durch Dotieren oder andere Maßnahmen ist auch die Schwindung beim Sintern zu berücksichtigen. Auch die Wärmedehnung und die Elastizität der Keramik des aktiven Bereichs A in Verbindung mit den thermischen und mechanischen Eigenschaften der Innenelektroden 3 und 4 muss mit der Ummantelung 9 kompatibel sein.

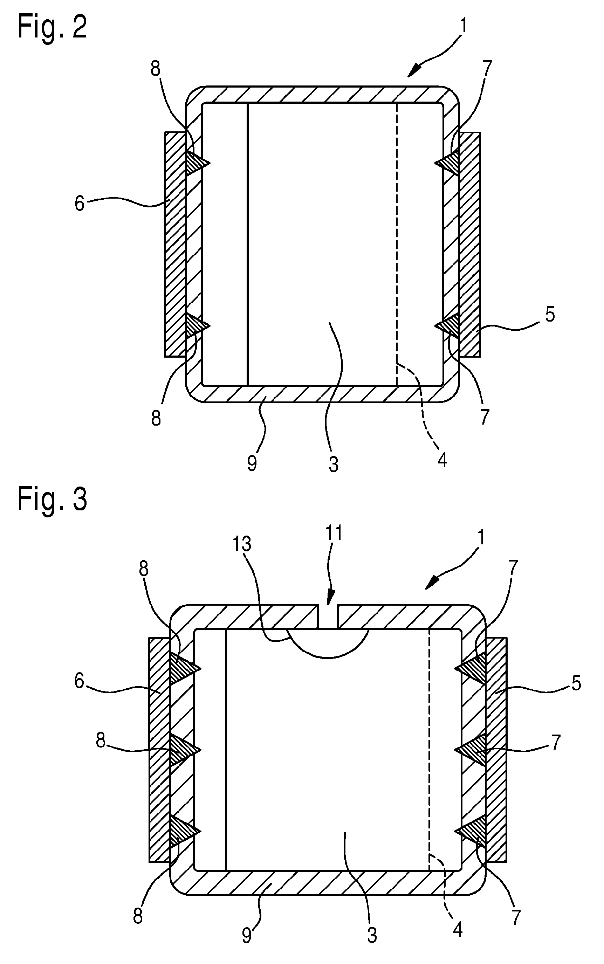

In den Figuren 2 bis 5 sind jeweils Querschnitte entlang der Linie D-D durch den Piezoaktor 1 dargestellt.

In Figur 2 ist ein erstes Ausführungsbeispiel eines erfindungsgemäßen Piezoaktors 1 entlang der Linie D-D geschnitten dargestellt. In der Schnittebene ist die Innenelektrode 3 sichtbar. Die darunter liegende Innenelektrode 4 ist nicht sichtbar und durch eine gestrichelte Linie dargestellt. Die Innenelektrode 3 wird über eine erste Außenelektrode 5 und Stege 7 elektrisch kontaktiert. Die Innenelektrode 4 wird über eine zweite Außenelektrode 6 und Stege 8 ebenfalls elektrisch kontaktiert. Die erste Außenelektrode 5 und die zweite Außenelektrode 6 weisen eine unterschiedliche Polarität auf. Infolgedessen haben auch die Innenelektroden 3 und 4 unterschiedliche Polaritäten, sobald Spannung an die Außenelektroden 5 und 6 angelegt wird, und es entsteht in den keramischen Schichten 2 das gewünschte elektrische Feld.

Wie aus Figur 2 gut ersichtlich, ist der Piezoaktor allseitig der Ummantelung 9 umgeben. Die Ummantelung 9 dient dazu, die Innenelektroden 3 und 4 einerseits gegen mechanische Schäden zu schützen und andererseits Kurzschlüsse zwischen den Innenelektroden 3 und 4 und einem den Piezoaktor umgebendes in Figur 2 nicht dargestelltes Gehäuse zu verhindern. Im Bereich der Außenelektroden 5 und 6 wird die Ummantelung 9 von den Stegen 7 und 8 durchbrochen.

Bei dem Ausführungsbeispiel gemäß Figur 2 ist die Ummantelung 9 durch Tauchen in einen Gießschlicker hergestellt. Die Ummantelung 9 kann vorzugsweise aus einem keramischen Werkstoff bestehen, dessen Grundsubstanz dem Grundwerkstoff des Piezoaktors 1 entspricht. Allerdings ist dieser Grundwerkstoff bei der Ummantelung 9 mit einem Metall dotiert. Dabei empfiehlt es sich, die Ummantelung 9 mit dem Metall oder der Metalllegierung zu dotieren, aus denen die inneren Elektroden 3 und 4 bestehen. Es hat sich nämlich gezeigt, dass beim Sintern von Piezoaktoren der Grundwerkstoff des piezoelektrisch aktiven Bereichs mit aus den inneren Elektroden 3 und 4 eindiffundierenden Metallatomen dotiert wird. Diese Dotierung beeinflusst die mechanischen und thermischen Eigenschaften des Grundwerkstoffs. Wenn nun die Ummantelung 9 ebenfalls aus einem dotierten Grundwerkstoff besteht, und die Dotierung nahezu identisch mit der von den inneren Elektroden 3 und 4 dotierten Piezoaktor 1 ist, führt dies dazu, dass die mechanischen und thermischen Eigenschaften der Ummantelung 9 den mechanischen und thermischen Eigenschaften des Piezoaktors 1 entsprechen und somit keine Wärmespannungen oder sonstigen unerwünschten Effekte dazu führen, dass die Ummantelung Risse bekommt oder sogar teilweise vom Piezoaktor 1 abplatzt.

In Figur 3 ist ein weiteres Ausführungsbeispiel eines erfindungsgemäßen Piezoaktors 1 ebenfalls entlang einer Linie die D geschnitten dargestellt. Gleiche Bauteile weisen das gleiche Bezugszeichen auf und es gilt das bezüglich der vorhergehenden Figuren Gesagte entsprechend. Bei dem Ausführungsbeispiel gemäß Figur 3 besteht die Ummantelung 9 aus einer um den Piezoaktor 1 gewickelten Folie aus einem keramischen Material. Diese Folie ist vor dem Sintern flexibel.

An den Enden der Folie ergibt sich ein Stoß 11, an dem die Isolationswirkung der Ummantelung 9 verringert ist. Um auch im Bereich des Stoßes 11 eine ausreichend hohe Sicherheit gegen elektrische Kurzschlüsse zu haben, ist dort die Innenelektrode 3 halbkreisförmig ausgespart. Diese Aussparung ist in Figur 3 mit dem Bezugszeichen 13 versehen. Es versteht sich von selbst, dass auch die darunter und darüber liegenden Innenelektroden 3 und 4 im Bereich des Stoßes 11, der sich ja über die gesamte Länge des Piezoaktors 1 erstreckt, entsprechende Aussparungen 13 aufweisen, die jedoch in Figur 3 nicht sichtbar sind.

Bei dem Ausführungsbeispiel gemäß Figur 3 sind jeweils drei Stege 7 und drei Stege 8 zwischen den Außenelektroden 5 und 6 einerseits sowie den Innenelektroden 3 und 4 andererseits vorhanden.

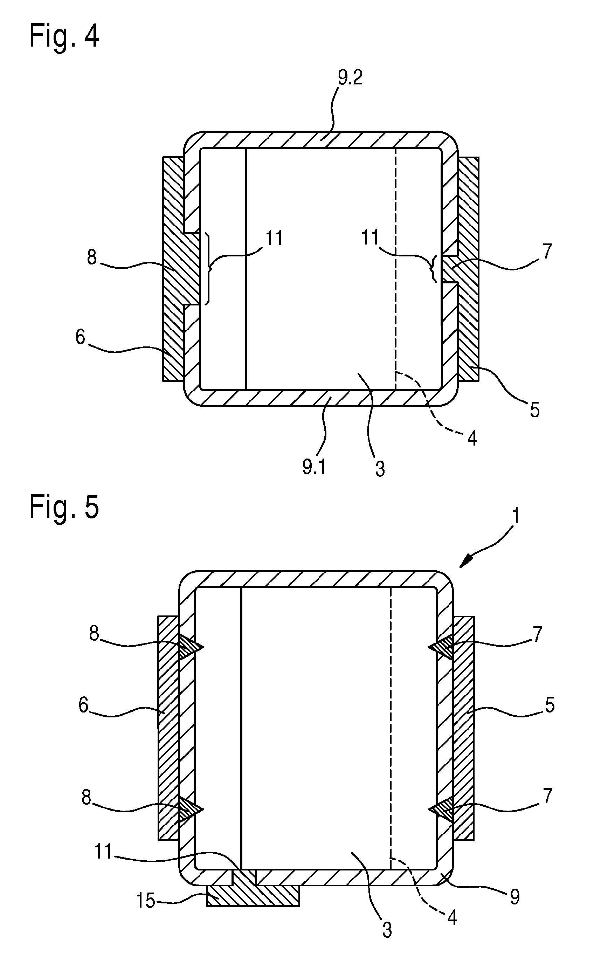

Bei dem Ausführungsbeispiel gemäß Figur 4 ist die Ummantelung 9 zweischalig ausgebildet. Die beiden Schalen sind in Figur 4 mit 9.1 und 9.2 bezeichnet. Naturgemäß treten bei diesem Ausführungsbeispiel zwei Stöße 11 auf. Im Bereich der Stöße 11 wird die elektrische Verbindung zwischen Außenelektroden 5 und 6 einerseits sowie den Innenelektroden 3 und 4 vorgenommen. Dies geschieht durch jeweils einen Steg 7 zwischen der ersten Außenelektrode 5 und den Innenelektroden 3 sowie einen Steg 8 zwischen der zweiten Außenelektrode 6 und den Innenelektroden 4. Bei diesem Ausführungsbeispiel ist, wie bei dem Ausführungsbeispiel gemäß Figur 2 auch, der Piezoaktor 1 vollständig von der Ummantelung 9 umschlossen.

In Figur 5 ist ein weiteres Ausführungsbeispiel eines erfindungsgemäßen Piezoaktors 1 dargestellt. Bei diesem Ausführungsbeispiel ist der Stoß 11 durch eine Dichtleiste 15 verschlossen. Auch durch diese Maßnahme wird die Kurzschlusssicherheit im Bereich des Stoßes 11 soweit erhöht, dass im Bereich des Stoßes 11 die Kurzschlusssicherheit genauso groß ist wie an den übrigen Bereichen der Ummantelung 9.

## Patentansprüche

1. Piezoaktor mit mehreren Schichten (2), wobei in einem piezoelektrisch aktiven Bereich
(A) zwischen den Schichten (2) Innenelektroden (3,4) vorgesehen sind und wobei die Innenelektroden (3, 4) mit einer elektrischen Spannung beaufschlagbar sind, **dadurch gekennzeichnet, dass** mindestens der piezoelektrisch aktive Bereich (A) mit einer Ummantelung (9, 9.1, 9.2) gegen elektrische Kurzschlüsse geschützt ist, und dass die Ummantelung (9, 9.1, 9.2) aus einem elektrisch nichtleitenden Material gebildet ist, dessen mechanische und thermische Eigenschaften den Eigenschaften des piezoelektrisch aktiven Bereichs (A) weitestgehend entsprechen.

2. Piezoaktor nach Anspruch 1, **dadurch gekennzeichnet, dass** die Ummantelung aus dem gleichen Grundwerkstoff wie die Schichten (3) des Piezoaktors bestehen.

3. Piezoaktor nach Anspruch 1 oder 2, **dadurch gekennzeichnet, dass** die mechanischen und thermischen Eigenschaften des piezoelektrisch aktiven Bereichs (A) durch das piezoelektrische Material der Schichten (2) und der Innenelektroden (3, 4) und deren Wechselwirkungen bestimmt werden.

4. Piezoaktor nach einem der vorhergehenden Ansprüche, **dadurch gekennzeichnet, dass** der Piezoaktor Außenelektroden (5, 6) aufweist, dass jede der Innenelektroden (3, 4) mit einer Außenelektrode (5, 6) elektrisch leitend verbunden ist, und dass die Außenelektroden (5, 6) im Wesentlichen außerhalb der Ummantelung (9, 9.1, 9.2) angeordnet sind.

5. Piezoaktor nach einem der vorhergehenden Ansprüche, **dadurch gekennzeichnet, dass** die Ummantelung (9, 9.1, 9.2) durch Tauchen des Rohlings eines Piezoaktors (1) in einen Gießschlicker und anschließendes Sintern erzeugt wird.

6. Piezoaktor nach einem der vorhergehenden Ansprüche, **dadurch gekennzeichnet, dass** die Ummantelung (9, 9.1, 9.2) aus einer Folie besteht, und dass die Folie um den Piezoaktor (1) gewickelt wird.

7. Piezoaktor nach Anspruch 5, **dadurch gekennzeichnet, dass** die Ummantelung (9, 9.1, 9.2) dort wo zwei Enden der Folie aufeinander treffen einen Stoß (11) aufweist, und dass die Innenelektroden (3, 4) einen Mindestabstand zu dem Stoß (11) nicht unterschreiten.

8. Piezoaktor nach Anspruch 6, **dadurch gekennzeichnet, dass** die Innenelektroden (3, 4) im Bereich des Stoßes (11) eine Aussparung (13) aufweisen.

9. Piezoaktor nach einem der Ansprüche 6 bis 8, **dadurch gekennzeichnet, dass** der Stoß (11) durch eine Leiste (15) oder einen Stopfen verschlossen ist.

10. Piezoaktor nach einem der vorhergehenden Ansprüche, **dadurch gekennzeichnet, dass** die Innenelektroden (3, 4) aus Silber (Ag) oder einer Silberlegierung, insbesondere einer Silber-Palladium-Legierung (AgPd), bestehen, und dass die Ummantelung (9, 9.1, 9.2) und/oder piezoelektrisch inaktive Bereiche (B, C) aus einem mit Silber dotierten keramischen Werkstoff, insbesondere Bleizirkonattitanat (PZT), besteht.

11. Piezoaktor nach einem der vorhergehenden Ansprüche, **dadurch gekennzeichnet, dass** die Innenelektroden (3, 4) aus Kupfer (Cu) oder einer Kupferlegierung bestehen, und dass die Ummantelung (9, 9.1, 9.2) und/oder die piezoelektrisch inaktiven Bereiche (B, C) aus einem mit Kupfer dotierten keramischen Werkstoff, insbesondere Bleizirkonattitanat (PZT), besteht.

12. Verfahren zur Herstellung einer Ummantelung (9, 9.1, 9.2) eines Piezoaktors (1), **dadurch gekennzeichnet, dass** ein Grünling des Piezoaktors (1) in einen Gießschlicker getaucht wird, und dass der Grünling des Piezoaktors (1) anschließend gesintert wird.

13. Verfahren nach Anspruch 12, **dadurch gekennzeichnet, dass** der Gießschlicker aus einem mit einem Metallsalz versetzten keramischen Werkstoff, insbesondere , insbesondere Bleizirkonattitanat (PZT), besteht.

14. Verfahren nach Anspruch 12 oder 13, **dadurch gekennzeichnet, dass** der Gießschlicker mit Silbersalzen und/oder Kupfersalzen versetzt ist.
